(19) Europäisches Patentamt

European Patent Office

Office européen des brevets

(11) Numéro de publication : **0 457 649 A1**

(12) **DEMANDE DE BREVET EUROPEEN**

(21) Numéro de dépôt : **91401183.8**

(51) Int. Cl.⁵ : **G01R 21/00**

(22) Date de dépôt : **06.05.91**

(30) Priorité : **17.05.90 FR 9006182**

(43) Date de publication de la demande :
**21.11.91 Bulletin 91/47**

(84) Etats contractants désignés :
**DE ES GB IT**

(71) Demandeur : **VALEO VISION**
**17, rue Henri Gautier**
**F-93012 Bobigny Cédex (FR)**

(72) Inventeur : **Ordines, Jean-Pierre**
**49, rue de la Gaité**
**F-92140 Clamart (FR)**

(74) Mandataire : **Lemaire, Marc**
**VALEO Service Propriété Industrielle 30, rue**
**Blanqui**
**F-93406 Saint-Ouen Cédex (FR)**

(54) **Circuit de mesure de la puissance instantanée.**

㊗ La présente invention concerne un circuit de mesure de la puissance instantanée absorbée aux bornes d'une charge résistive comme une lampe à décharge.

L'invention se caractérise principalement en ce que le circuit de mesure comporte :

— un moyen de mesure (41,47,48) d'une basse tension (UM) au pied du secondaire du transformateur, ladite tension (UM) étant une image de la tension (U30) aux bornes de la charge (30),

— un moyen de mesure (42) du courant traversant le secondaire du transformateur de courant ayant la même phase que ladite basse tension mesurée (UM), et étant une image du courant traversant la charge (30),

— des circuits redresseurs (45,46) dudit courant et de ladite tension mesurés,

— un circuit de traitement (49) des signaux redressés destiné à élaborer un signal (50) représentatif de la puissance instantanée absorbée par la charge (30).

EP 0 457 649 A1

Jouve, 18, rue Saint-Denis, 75001 PARIS

FIG.3

La présente invention concerne un circuit de mesure de la puissance instantanée absorbée aux bornes d'une charge non réactive comme une lampe à décharge.

L'invention concerne aussi un circuit d'éclairage utilisable notamment dans un véhicule, le circuit étant du type comportant une lampe à décharge alimentée à travers une alimentation à découpage et un transformateur.

L'invention trouve application principalement dans le domaine de l'automobile.

Dans l'art antérieur on a déjà proposé des dispositifs permettant de mesurer en permanence la puissance dissipée par une lampe à décharge.

En effet la fiabilité d'un circuit d'éclairage ainsi que le rendement lumineux des phares dépendent largement de la puissance fournie par l'alimentation à la lampe à décharge.

En effet, il faut que la puissance fournie à la lampe à décharge soit strictement contrôlée au cours de la décharge.

Dans l'art antérieur on a déjà prévu des dispositifs permettant de mesurer simultanément la tension et le courant traversant une charge résistive.

Mais dans le cas de l'invention, le point chaud de la lampe à décharge est placé à haute tension. De ce fait les mesures directes ne sont pas envisageables dans les applications automobiles.

On a aussi proposé une autre solution consistant à mesurer le courant traversant la lampe à décharge et la tension aux bornes d'un groupe de quelques spires sélectionnées au pied du secondaire du transformateur d'alimentation de la lampe à décharge.

Mais une telle solution présente divers inconvénients qui seront développés plus loin. En particulier, une telle solution exige le recours à un multiplicateur analogique quatre quadrants.

En effet le courant et la tension mesurés n'ont pas de rapport de phase ce qui fait qu'on est contraint de calculer le produit signé courant par tension mesurés.

De tels circuits de multiplication exigent des alimentations positive et négative, rendant complexe l'utilisation de ce genre de solution dans des applications automobiles.

Afin de remédier à ces inconvénients de l'art antérieur, la présente invention concerne un circuit de mesure de la puissance instantanée aux bornes d'une charge résistive comme une lampe à décharge. La lampe à décharge est alimentée par un circuit à découpage à travers un transformateur de tensions.

L'invention se caractérise principalement en ce que le circuit de mesure comporte :
 – un moyen de mesure d'une basse tension au pied du secondaire du transformateur, ladite tension étant une image de la tension aux bornes de la charge,
 – un moyen de mesure du courant traversant le secondaire du transformateur, ledit courant ayant la même phase que ladite basse tension mesurée,
 – des circuits redresseurs dudit courant et de ladite tension mesurés,
 – et un circuit de traitement des signaux redressés, destiné à élaborer un signal représentatif de la puissance instantanée absorbée par la charge résistive.

L'invention concerne aussi un circuit d'éclairage, notamment pour véhicules.

Un tel circuit d'éclairage est du type comportant une lampe à décharge alimentée à travers un transformateur par une alimentation à découpage à rapport cyclique et fréquence réglables.

L'invention se caractérise notamment en ce que le circuit d'éclairage comporte aussi un circuit de mesure de la puissance instantanée absorbée aux bornes de la lampe à décharge selon l'invention et dont la sortie est connectée à un circuit de pilotage de la fréquence et du rapport cyclique de l'alimentation à découpage.

D'autres caractéristiques et avantages de la présente invention seront mieux compris à l'aide de la description et des figures annexées qui sont :
 – la figure 1 : un diagramme courant/tension aux bornes de la lampe à décharge,
 – la figure 2 : un schéma électrique d'un mode de réalisation selon l'art antérieur,
 – la figure 3 : un schéma électrique d'un mode de réalisation de la présente invention.

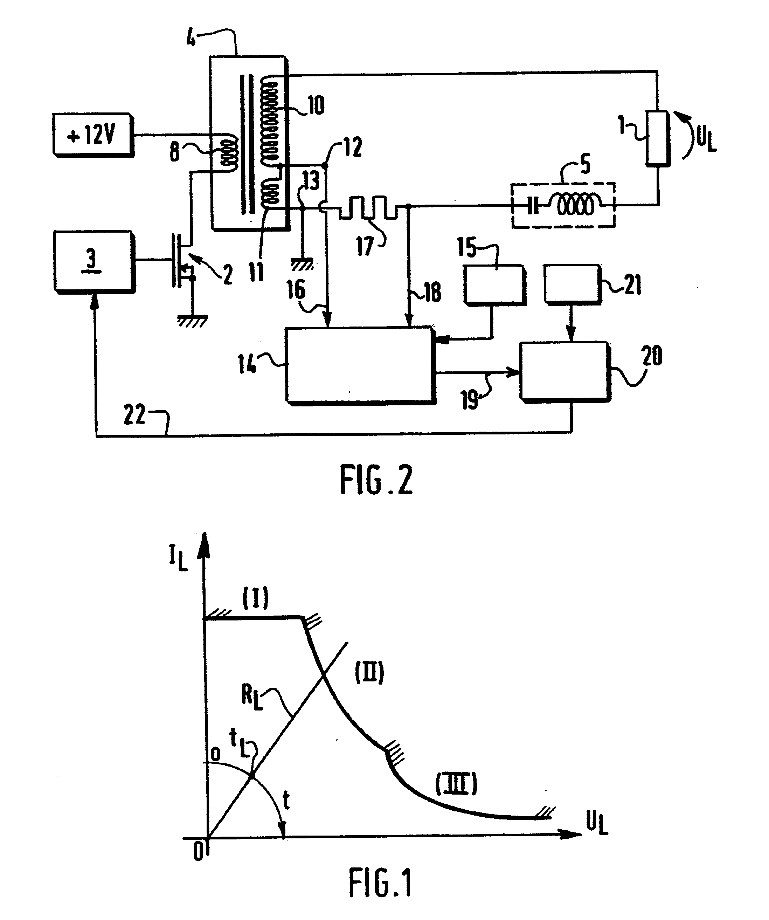

A la figure 1, on a représenté un diagramme de la puissance absorbée aux bornes d'une lampe à décharge. En abscisse on a porté le courant traversant la lampe d'une part et en ordonnée la tension aux bornes de la lampe.

Le diagramme de puissance comporte trois régions I,II,III successives depuis l'établissement de l'arc jusqu'au régime permanent.

La résistance instantanée de la lampe RL en un point de cette courbe en trois parties est mesurée par le rapport UL/IL, tandis que les angles comptés à partir de l'ordonnée vers l'abscisse représentent le temps d'établissement du régime permanent.

Pour un fonctionnement convenable, il faut que l'alimentation de la lampe à décharge ne dépasse pas la courbe en trois parties de la figure 1. Plus on s'approche de cette courbe, meilleures sont les performances du système d'éclairage.

Ceci impose en général un contrôle de puissance aussi précis et fiable que possible.

Dans l'art antérieur représenté dans une réalisation à la figure 2, on a déjà proposé un moyen pour contrôler cette puissance absorbée instantanée.

Le transformateur 4 comporte un primaire 8 dont le point chaud est connecté à l'alimentation générale du circuit comme une tension de + 12V, tandis que le pied de l'enroulement est connecté à un transistor de découpage 2. La grille du transistor de découpage 2 est commandée par un oscillateur à rapport cyclique et fréquence réglables 3.

Entre le pied 13 du secondaire du transformateur 4 et le point froid de la lampe à décharge 1, on est contraint de disposer en général un dipôle 5 d'adaptation constitué d'un condensateur 6 et d'une inductance 7. Dans d'autres cas, le dipôle est seulement constitué d'une capacité. Les caractéristiques de ce dipôle sont déterminées en tenant compte des exigences du constructeur de la lampe à décharge 1.

Pour effectuer une mesure de puissance instantanée, dans l'art antérieur on a proposé un système dans lequel on réalise un bobinage partiel 11 au pied du secondaire, par exemples trois spires, aux bornes duquel on mesure 16 la tension instantanée.

D'autre part, entre le pied de l'enroulement secondaire 13 et le dipôle 5, on place une résistance 17 qui permet de mesurer le courant traversant le secondaire 10,11, le courant consommé au point 12 étant faible.

De ce fait, le courant traversant la résistance 17 est égal à chaque instant au courant traversant la lampe à décharge.

D'autre part, la tension mesurée au point 12 par rapport à la masse 13 est proportionnelle à la tension aux bornes du secondaire. Cette tension aux bornes d'une secondaire évolue sensiblement comme la tension aux bornes d'une charge résistive 1. Cependant le dipôle 5 entraîne une perturbation de phase et d'amplitude entre ces deux mesures.

Dans cette réalisation de l'art antérieur, on a résolu le problème constitué par la mesure de la haute tension en évitant de faire les mesures au point chaud, mais en contrepartie à cause de l'influence du dipôle 5, on est contraint d'utiliser un multiplicateur 4 quadrants pour déduire la mesure de puissance. Ceci est un autre inconvénient de l'art antérieur.

Les mesures de courant 18 et de tension 16 sont fournies à ce multiplicateur analogique 14. Du fait que la loi de phase entre ce courant et cette tension est inconnue, on est contraint de réaliser une multiplication dans les quatre quadrants du graphe tension/intensité.

Le résultat en sortie 19 du multiplicateur analogique 14 est proportionnel au produit du courant traversant la lampe par la tension aux bornes du secondaire. Ce signal peut être alors traité par un circuit de pilotage 20 asservi à une consigne 21, qui élabore un signal 22 de pilotage de l'oscillateur à rapport cyclique et fréquence réglables.

D'autre part, le multiplicateur analogique à quatre quadrants 14 doit être alimenté à travers des alimentations positive et négative.

Un tel schéma exige donc une autre source de tension que la source d'alimentation principale du véhicule.

Afin de porter remède à ces inconvénients de l'art antérieur, la présente invention propose un moyen permettant de mesurer simultanément le courant et la tension aux bornes de la lampe à décharge sans av. à se placer près de la haute tension, c'est-à-dire a. points chauds.

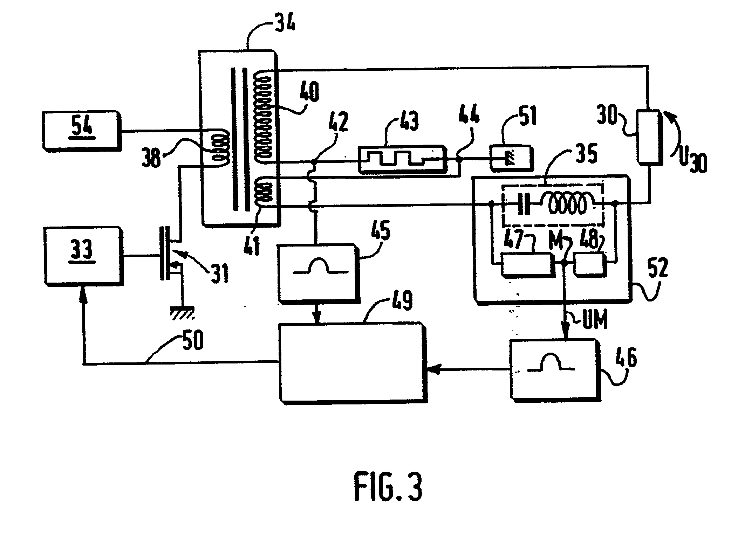

A la figure 3, on a représenté un mode de réalisation selon la présente invention. Le circuit d'éclairage comporte une lampe à décharge 30 connectée aux bornes du secondaire 40,41 d'un transformateur 34. Le transformateur 34 comporte un primaire 38 dont le point chaud est connecté à l'alimentation du véhicule et le pied est connecté au drain du transistor de commutation 31.

Selon l'invention, le secondaire du transformateur est partagé en deux bobinages 40 et 41. Le bobinage 40 est constitué du côté de la haute tension et le bobinage 41 comportant quelques spires est constitué du côté de la masse. Une résistance 43 est connectée entre les deux bobinages 40 et 41. Le bobinage 41 est connecté 44 d'une part à la résistance 43 d'autre part à la masse 52. Dans un autre mode de réalisation ce point est relié à une source de tension qui permet un décalage en tension du montage. Le pied 42 du bobinage est un point de mesure de l'intensité traversant le secondaire et donc la charge 30. Dans ce mode de réalisation la mesure en 42 du courant est une image identique au courant traversant la charge 30.

La grille du transistor de commutation 31 est reliée à la sortie d'un oscillateur 33 à rapport cyclique et fréquence réglables.

D'autre part le pied de l'enroulement secondaire 41 est connecté au point froid de la lampe à décharge à travers le dipôle d'adaptation 35, déjà décrit à la figure 2.

Selon l'invention, un bobinage partiel 41 est réalisé au pied du secondaire du transformateur 34. D'autre part, on constitue une échelle de résistances 47,48 aux bornes du dipôle 35. Le point M commun aux résistances 47 et 48 est un point sur lequel la tension par rapport à la masse est proportionnelle à la tension aux bornes de la lampe, et en phase avec celle-ci. La tension de mesure UM en ce point, par rapport au point 51, est une image de la tension aux bornes de la charge 30.

En effet, si le premier bobinage 40 du secondaire comporte N1 spires, et que le second bobinage 41 comporte N2 spires, le rapport des nombres de spires est exprimé par :

$$K = N2/N1 + N2$$

Selon l'invention, on choisit les résistances 47 de valeur R2 et 48 de valeur R1 de telle sorte que :

$$K = R2/R1 + R2$$

De ce fait, la tension du point M par rapport à la masse s'exprime par la relation :

$$UM = K \cdot U35 - K \cdot US$$

où U35 est la tension aux bornes du dipôle 35 et US la tension aux bornes du secondaire complet.
De ce fait :

UM = - K (US - U35)

et comme UL = US - U35 on en déduit que UM = - K UL, avec UL tension aux bornes de la charge 30.

De ce fait, la tension mesurée au point M est l'image exacte de la tension UL aux bornes de la lampe à décharge. D'autre part, la charge étant purement résistive, la tension à ses bornes et le courant qui la traverse sont en phases, il en est de même pour leurs images.

Il est donc possible de travailler dans le premier quadrant du diagramme courant-tension. De ce fait on évite le recours à un multiplicateur analogique et on peut se contenter de réaliser un redressement du courant mesuré au point 42 et de la tension mesurée à la borne commune M des résistances 47 et 48.

Selon l'invention, on dispose d'un premier circuit redresseur 45 pour redresser le courant mesuré en 42 et un redresseur 46 pour redresser la tension mesurée au point M.

Les sorties redressées sont fournies à des convertisseurs analogiques numériques non représentés aux dessins, dont les sorties sont exploitées par un microprocesseur dont le programme exécute un calcul instantané de la puissance absorbée pendant le rapport cyclique de découpage de l'oscillateur 33. Dans un mode de réalisation préféré, les convertisseurs analogiques numériques sont intégrés au boîtier du microprocesseur.

La sortie du microprocesseur 49 permet de renvoyer un signal 50 pour asservir en fonction d'un programme convenablement établi pour régler le rapport cyclique et fréquence de l'oscillateur 33.

Dans le mode de réalisation décrit ci-dessus, on a utilisé comme moyen pour engendrer la tension image de la tension U30 aux bornes de la charge un pont de deux résistances. Mais, d'autres impédances sont envisageables en fonction de la complexité du fonctionnement de la charge.

Le circuit qui réalise la tension image UM engendre un signal en phase avec l'intensité mesurée au point 42. De ce fait, la mesure de la puissance, côté basse tension du circuit, est possible sans erreur ni complication.

**Revendications**

1) Circuit de mesure de la puissance instantanée aux bornes d'une charge non réactive (30) comme une lampe à décharge alimentée par un circuit à découpage (31) à travers un transformateur (38) de tensions, caractérisé en ce qu'il comporte :

    – un moyen de mesure (41,47,48) d'une basse tension (UM) au pied du secondaire du transformateur, ladite tension (UM) étant une image de la tension (U30) aux bornes de la charge (30),

    – un moyen de mesure (42) du courant traversant le secondaire du transformateur de courant ayant la même phase que ladite basse tension mesurée (UM), et étant une image du courant traversant la charge (30),

    – des circuits redresseurs (45,46) dudit courant et de ladite tension mesurés,

    – un circuit de traitement (49) des signaux redressés destiné à élaborer un signal (50) représentatif de la puissance instantanée absorbée par la charge (30).

2) Circuit selon la revendication 1, caractérisé en ce que le moyen de mesure du courant est constitué par une prise (42) au point froid d'un premier bobinage (40) constitué au secondaire du transformateur (34).

3) Circuit selon la revendication 2, caractérisé en ce que le moyen de mesure de la tension image (UM) comporte au secondaire du transformateur (38) un second bobinage (41) composé d'un nombre (N2) de spires inférieur au nombre (N1) de spires du premier bobinage, dont une première extrémité est connectée à une extrémité d'une impédance (43), et une seconde extrémité est connectée à un circuit (47,48) destiné à élaborer une basse tension de mesure (UM) comme image instantanée de la tension (U30) aux bornes de la charge (30), l'autre extrémité de l'impédance (43) étant connectée au pied du premier bobinage (40) du secondaire.

4) Circuit selon la revendication 3, caractérisé en ce que l'impédance est une résistance (43), connectée à une source de tension (51), comme la masse.

5) Circuit selon la revendication 3, caractérisé en ce que le circuit destiné à élaborer une basse tension de mesure (UM) comporte un diviseur de tension (47,48) composé par deux impédances connectées en série entre le point froid de la charge (30) et l'autre extrémité du second bobinage (41).

6) Circuit selon la revendication 5, caractérisé en ce que le rapport des impédances est égal au rapport des nombres de spires entre des premier et second bobinages.

7) Circuit selon la revendication 5, caractérisé en ce que les impédances sont des résistances.

8) Circuit selon la revendication 1, caractérisé en ce que le circuit de traitement (49) exécute le produit des signaux de sortie des redresseurs (45 et 46) sous forme analogique ou numérique.

9) Circuit d'éclairage, notamment pour véhicule, du type comportant une lampe à décharge alimentée à travers un transformateur par une alimentation à découpage à rapport cyclique et fréquence réglables, caractérisé en ce qu'il comporte un circuit de mesure de la puissance instantanée absorbée aux bornes de la lampe à décharge dont la sortie est connectée à un circuit de pilotage selon l'une au moins des revendications précédentes.

FIG.2

FIG.1

FIG.3

EP 0 457 649 A1

Office européen
des brevets

**RAPPORT DE RECHERCHE EUROPEENNE**

Numero de la demande

EP 91 40 1183

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-2 099 594 (HILBRE) <br> * Résumé; page 2, lignes 77-123 * <br> --- | 1 | G 01 R 21/00 |
| A | US-A-4 833 401 (CANADIAN PATENTS) <br> ----- | | |

DOMAINES TECHNIQUES RECHERCHES (Int. Cl.5)

G 01 R

Le présent rapport a été établi pour toutes les revendications

| Lieu de la recherche | Date d'achèvement de la recherche | Examinateur |
|---|---|---|
| LA HAYE | 26-06-1991 | HOORNAERT W. |